# EUROPEAN PATENT APPLICATION

(11) **EP 4 583 297 A1**
(43) Date of publication of application: **09.07.2025**
(21) Application number: 24844203.0
(22) Date of filing: 18.02.2024
(51) Int. Cl.: H01M 50/503

(54) **CCS CONNECTING SHEET, CCS ACQUISITION LOOP AND BATTERY PACK**

(30) Priority: 24.07.2023 CN 202321963410 U
(71) Applicant: Eve Energy Co., Ltd., Huizhou, Guangdong 516006 (CN)
(72) Inventor: MA, Jinsi, Huizhou, Guangdong 516006 (CN)
(74) Representative: Berggren Oy
(86) International application number: PCT/CN2024/077363
(87) International publication number: WO 2025/020504

(57) **Abstract**

A cells contact system (CCS) connecting sheet, a CCS acquisition circuit, and a battery pack are provided. The CCS connecting sheet includes a connecting sheet body (1). The connecting sheet body (1) includes a first region (11) and a second region (12). A thickness of the second region (12) is less than a thickness of the first region (11) to form at least one step (3) at a junction therebetween. An outer surface of the second region (12)is provided with a nickel-plating layer.

## Description

This application claims priority to the benefit of Chinese Patent Application No. 202321963410.7, filed on July 24, 2023, the disclosure of which is incorporated herein by reference in its entirety.

### TECHNICAL FIELD

The present application relates to a technical field of batteries, in particular to cells contact system (CCS) connecting sheets, CCS acquisition circuits, and battery packs.

### BACKGROUND

In the related art, the acquisition of battery modules is generally soldered with nickel sheets through flexible printed circuits (FPC), and then the nickel sheets and aluminum rows are soldered through laser welding to form acquisition circuits. That is, a connection mode is that: pole of battery cell-aluminum row-nickel sheet-FPC-connector-wiring harness-battery management system (BMS).

Therefore, according to the above, it can be known that the acquisition circuits need to be transferred through the nickel sheets to realize an electrical connection between the FPC and the aluminum rows, and process flows are increase due to the transfer of the nickel sheets. The acquisition circuits are transferred through the nickel sheets, and the separate nickel sheets are required due to the cross connection between the FPC and the aluminum rows, which increases the material cost of the nickel sheets.

### SUMMARY

A cells contact system (CCS) connecting sheet, a CCS acquisition circuit, and a battery pack are provided by the present application to solve the technical problem mentioned above.

In a first aspect, a CCS connecting sheet provided by the present application includes a connecting sheet body. The connecting sheet body includes a first region and a second region. A thickness of the second region is less than a thickness of the first region to form at least one step at a junction therebetween. An outer surface of the second region is provided with a nickel-plating layer.

In a second aspect, a CCS acquisition circuit provided by the present application includes a plurality of CCS connecting sheets and a flexible printed circuit (FPC). The plurality of CCS connecting sheets are arranged side by side to form an aluminum row, and the aluminum row is connected to the FPC.

In a third aspect, a battery pack provided by the present application includes the CCS acquisition circuit and a battery module. The CCS acquisition circuit is connected to the battery module.

### BENEFICIAL EFFECTS

The beneficial effects of the present application are illustrated below. In the CCS connecting sheet provided by the present application, the nickel-plating layer is disposed on the second region, which can reduce material consumption, save costs, simplify the welding process, and improve the assembly efficiency between the aluminum row and the FPC. Moreover, in the connecting sheet body, the thickness of the second region is less than the thickness of the first region, which effectively reduces an overall thickness between the second region and the FPC and improves space utilization, when the second region is connected to the FPC. Moreover, the thickness of the second region is less than the thickness of the first region, and the at least one step is provided between the second region and the first region, which can facilitate the overlap between the second region and the FPC for welding.

The CCS acquisition circuit provided by the present application includes the CCS connecting sheet mentioned above. The nickel-plating layer is disposed on the second region, which can reduce material consumption, save costs, simplify the welding process, and improve the assembly efficiency between the aluminum row and the FPC. Moreover, in the connecting sheet body, the thickness of the second region is less than the thickness of the first region, which effectively reduces an overall thickness between the second region and the FPC and improves space utilization, when the second region is connected to the FPC. Moreover, the thickness of the second region is less than the thickness of the first region, and the at least one step is provided between the second region and the first region, which can facilitate the overlap between the second region and the FPC for welding.

The battery pack provided by the present application includes the CCS acquisition circuit mentioned above. The CCS acquisition circuit includes the CCS connecting sheets. The nickel-plating layer is disposed on the second region, which can reduce material consumption, save costs, simplify the welding process, and improve the assembly efficiency between the aluminum row and the FPC. Moreover, in the connecting sheet body, the thickness of the second region is less than the thickness of the first region, which effectively reduces an overall thickness between the second region and the FPC and improves space utilization, when the second region is connected to the FPC. Moreover, the thickness of the second region is less than the thickness of the first region, and the at least one step is provided between the second region and the first region, which can facilitate the overlap between the second region and the FPC for welding.

### BRIEF DESCRIPTION OF THE DRAWINGS

FIG. 1 is a front view of a CCS connecting sheet according to an embodiment of the present application.
FIG. 2 is a side view of the CCS connecting sheet according to an embodiment of the present application.
FIG. 3 is a schematic structural view of an aluminum row according to an embodiment of the present application.
FIG. 4 is an enlarged schematic view at a position C shown in FIG. 3.
FIG. 5 is a schematic structural view of Embodiment 3 of the present application.
FIG. 6 is a schematic structural view of a battery pack according to an embodiment of the present application.

### Reference numbers:

1, connecting sheet body; 11, first region; 111, connecting edge; 12, second region; 21, body; 211, connecting port; 212, avoidance port; 22, connecting block; 221, marginal region; 3, step; 4, plastic bracket; 5, low-voltage connector; 6, temperature sensor; 7, patch fuse; 8, battery module.

### DETAILED DESCRIPTION

In the present application, unless otherwise specified and defined, terms "connect", "contact", and "fix" should be understood in a broad sense. For example, it may be a fixed connection, a detachable connection, or made as a whole. It may be a mechanical connection or an electrical connection. It may be a direct or indirect connection through an intermediate media. It may be an internal connection between two components or an interaction relationship between two components. For those skilled in the art, meanings of the above terms in the present application can be understood according to situations.

In the present application, unless otherwise specified and defined, a first feature is disposed "on" or "under" a second feature may include a direct contact between the first feature and the second feature, or a contact between the first feature and the second feature through other features rather than the direct contact. Moreover, that the first feature is disposed "above" or "up" the second feature includes that the first feature is directly above or obliquely above the second feature, or only indicate that a horizontal height of the first feature is greater than a horizontal height of the second feature. That the first feature is disposed "below", "under", or "underneath" of the second feature includes that the first feature is directly below or obliquely below the second feature, or only indicates that the horizontal height of the first feature is less than the horizontal height of the second feature.

In description of the present application, orientational or positional relationships represented by directional terms mentioned in the present application, such as "up", "down", "right", etc., are orientational or positional relationships based on the drawings, and are merely for the convenience of describing the present application and simplifying the description, rather than indicating or implying that the device or element is intended to have a particular orientation, or is constructed and operated in a particular orientation, and therefore, should not be interpreted as a limitation of the application. In addition, the terms "first" and "second" are merely used to distinguish in description, and do not have a special meaning.

### Embodiment 1

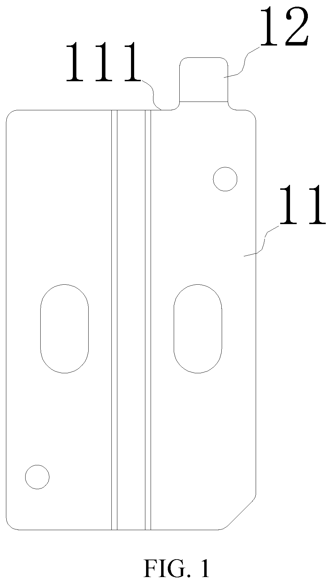

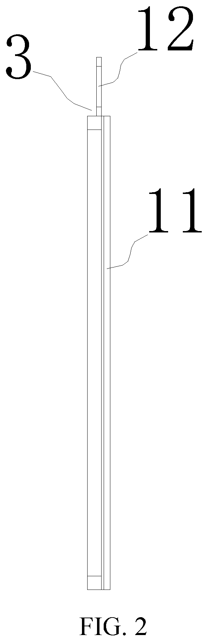

Referring to FIG. 1 and FIG. 2, the present application provides a cells contact system connecting sheet (CCS), which refers to an integrated busbar, including a connecting sheet body 1.

The connecting sheet body 1 includes a first region 11 and a second region 12. A thickness of the second region 12 is less than a thickness of the first region 11. The second region 12 is nickel-plated. Optionally, the connecting sheet body 1 may be an aluminum sheet body or a copper sheet body. In this embodiment, the connecting sheet body 1 is preferably the aluminum sheet body.

In this embodiment, the thickness of the first region 11 is less than or equal to 2 mm. The thickness of the second region 12 ranges from 0.3 mm to 1.5 mm. whereby it can be known that the thickness of the first region 11 ranges from 1.5 mm to 2 mm.

Preferably, both the first region 11 and the second region have a square profile. Preferably, both the first region 11 and the second region 12 have a rectangular profile. The thickness of the first region 11 is 1.5 mm, and the thickness of the second region 12 is 0.5 mm. Certainly, the thickness of the first region 11 may also take a limit value of 2 mm or another value between 1.5 mm and 2 mm, such as 1.6 mm, 1.7 mm, 1.8 mm, and 1.9 mm. Similarly, the thickness of the second region 12 may also take a limit value of 0.3 mm or 1.5 mm, or another value between 0.3 mm and 1.5 mm, which will not be listed herein.

Furthermore, the first region 11 is configured with a connecting edge 111, and the second region 12 is connected to the connecting edge of the first region 11. An edge of the second region 12 connected to the connecting edge 111 is a first long edge of the second region 12. Specifically, according to the above, the first region 11 has a rectangular profile, and two long edges of the first region 11 are perpendicularly connected to the connecting edge 111. The second region 12 is configured with an edge parallel to the connecting edge 111. The edge of the second region 12 parallel to the connecting edge 111 is a first wide edge of the second region 12. Specifically, according to the above, the second region 12 has a rectangular profile, and the second region 12 is parallel to the connecting edge 111. A size of the first long edge ranges from 6 mm to 7 mm, and a size of the first wide edge ranges from 5.5 mm to 6.5 mm.

Preferably, the first long edge of the second region 12 is 6.5 mm, and the first wide edge is 6 mm. The first long edge of the second region 12 may also take a limit value of 6 mm or 7 mm, or other values between 6 mm and 7 mm, which will not be listed herein.

Based on the above, the size of the first long edge ranges from 6 mm to 7 mm, and the size of the first wide edge ranges from 5.5 mm to 6.5 mm, so that the second region 12 in these size ranges has a sufficient external connection position, which can be used for welding and other operations with external components. Moreover, after the welding of the second region 12 is completed, there is no excessive blank area, thereby avoiding material waste and effectively controlling costs.

In particular, in this embodiment, a length of an edge of the first region 11 parallel to the first wide edge is 5-6 times a length of the first wide edge, and a length of an edge of the first region 11 parallel to the first long edge is 8-9 times a length of the first long edge.

Preferably, in this embodiment, the length of the edge of the first region 11 parallel to the first wide edge is 5 times the length of the first wide edge, and the length of the edge of the first region 11 parallel to the first long edge is 8 times the length of the first long edge.

In addition, a thickness of the nickel-plating layer of the second region 12 ranges from 5 µm to 15 µm. Preferably, in this embodiment, the thickness of the nickel-plating layer is 7 µm. Certainly, the thickness of the nickel-plating layer can also be taken as 5 µm, 9 µm, 11 µm, 13 µm, or 15 µm, as well as other values within this rang.

In particular, in this embodiment, the second region 12 is disposed an end adjacent to a side of the side edge of the first region 11.

Other feasible solutions further include that the second region 12 may have a triangular profile or an arcuate profile, so that the triangular profile has no wide edge, and the arcuate profile does not distinguish between long edge and wide edge. Alternatively, the second region 12 may be a trapezoidal contour, and two waists of the second region 12 of the trapezoidal contour are the long edges.

### Embodiment 2

Based on the the Embodiment 1, referring to FIG. 2, it can be known that since the thickness of the second region 12 is less than the thickness of the first region 11, the second region 12 is disposed between the thickness range of the first region 11. Preferably, in a thickness direction of the first region 11, a center of the second region 12 and a center of the first region 11 are aligned. It can be known that the steps 3 are provided between a bottom surface of the second region 12 and a bottom surface of the first region 11, and between a top surface of the second region 12 and a top surface of the first region 11. A step drop between the two steps 3 are equal. It can be known that if the center of the second region 12 and the center of the first region 11 are not aligned in the thickness direction of the first region 11, the step drop between the two steps 3 on the top surface and the bottom surface of the second region 12 are not equal.

Optionally, in the thickness direction of the first region 11, the bottom surface of the second region 12 and the bottom surface of the first region 11 are aligned. In this case, the step 3 is provided between the top surface of the second region 12 and the top surface of the first region 11. Alternatively, in the thickness direction of the first region 11, the top surface of the second region 12 and the top surface of the first region 11 are aligned, and it can be known that the step 3 is provided between the bottom surface of the second region 12 and the bottom surface of the first region 11.

When the second region 12 is connected to the external components, the external components can be overlapped on the step 3, so as to facilitate direct welding between the step 3 and the external components. After the step 3 and the external components are welded, an overlapping projection will not be formed on an overlapping joint between the external components and the second region 12, thereby effectively avoiding the collision between the welding position and the outside world. In addition, the above-mentioned setting of the steps with different step drops allows the second region 12 to adaptively adjust its connection position with the first region 11 when welding with different external components, thereby improving the applicability of the CCS connecting sheet.

In particular, the step drops of all the steps 3 of the second region 12 are formed by punching. The steps 3 are formed by the punching forming process, indicating that the first region 11 and the second region 12 may be integrally connected, and the integrally connected first region 11 and second region 12 improve the overall stiffness of the CCS connecting sheet.

### Embodiment 3

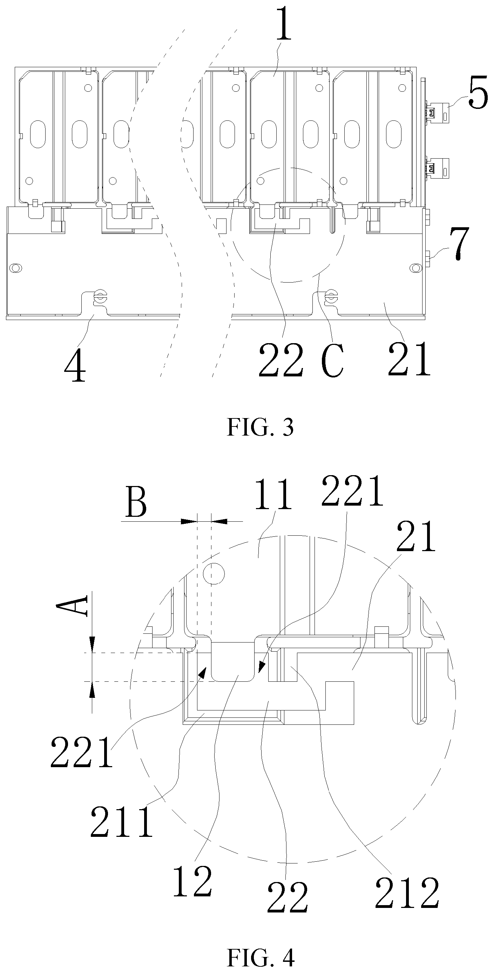

Based on the Embodiment 1 and the Embodiment 2, referring to FIG. 3 and FIG. 4, a CCS acquisition circuit includes the CCS connecting sheets mentioned above and a flexible printed circuit (FPC). A plurality of CCS connecting sheets are arranged side by side to form an aluminum row. The aluminum row is connected to the FPC.

Preferably, a body 21 is provided with a connecting port 211. A connecting block 22 is disposed in the connecting port 211. One end of the connecting block 22 is connected to a side wall of the connecting port 211, and the other end is a free end. The connecting block 22 is disposed in the connecting port 211, so that the connecting block 22 can be effectively hided, thereby avoiding interference between the connecting block 22 and the external components, and improving the compactness of an overall structure of the FPC.

The second region 12 is connected to the connecting block 22 and overlapped with the connecting block 22. Specifically, an overlapping length between the long edge and the connecting block 22 ranges from 3 mm to 5 mm. For convenience of description, the overlapping length is A. In this embodiment, the overlapping length is 4 mm. The connecting block 22 is provided with a marginal region 221. The marginal region 221 is located at a side of the long edge. A distance of the marginal region 221 extending towards a direction away from the long edge ranges from 1.5 mm to 3 mm. For convenience of description, the distance is B. In this embodiment, the distance is 2 mm. The size range of the B can ensure that the marginal region 221 has a sufficient region to be left blank, so that the welding between the second region 12 and the connecting block 22 will not be misaligned and shifted, and the welding reliability between the second region 12 and the connecting block 22 is guaranteed.

Specifically, according to the above, it can be known that the second region 12 is connected to the connecting block 22. That is, the second region 12 is overlapped on an outer edge of the connecting block 22 (referring to the Embodiment 2, in this case, the connecting block 22 is overlapped with a first step 3, and the connecting block 22 and the second region 12 are welded). Referring to FIG. 4, a right end of the connecting block 2 is connected to a right side wall of the connecting port 211, and a distance from a left long edge of the second region 12 to a left side edge of the connecting block 2 is B. On this basis, in order to make the flexibility of the connecting block 22 greater, the connecting block 22 is provided with an avoidance port 212, and the avoidance port 212 is a U-shaped port provided on the outer edge of the connecting block 22. The avoidance port 212 is located on a right side of the second region 12 (that is, the second region 12 is located between the avoidance port 212 and the free end). Certainly, a distance from a right long edge of the second region 12 to a left side wall of the avoidance port 212 is also B. From the above, it can be known that the area where a distance between the two long edges on the connecting block 22 is B is the marginal region 221.

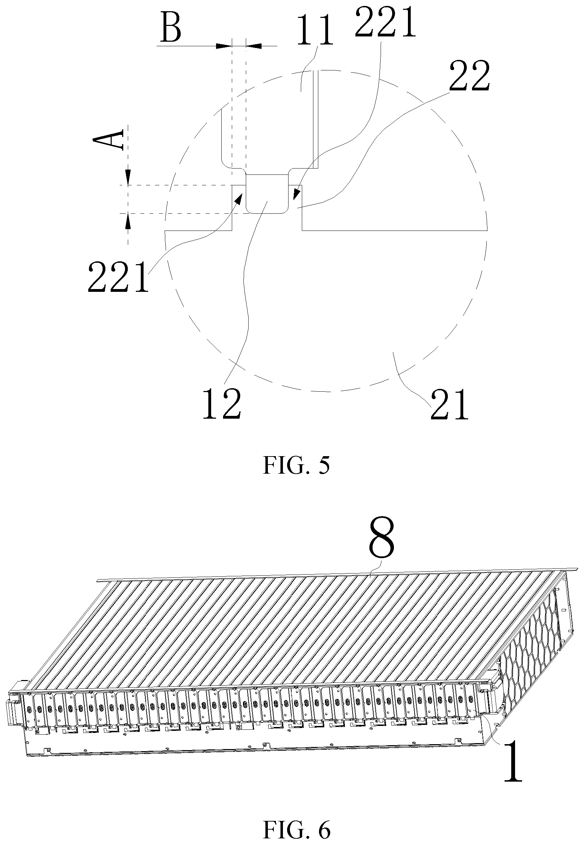

In addition, referring to FIG. 5, the body 21 may not be provided with the connecting port 211, so that one end of the connecting block 22 is connected to the side edge of the body 21 and extends in a direction away from the center of the body 21 (this extending end is the free end). Preferably, the connecting block 22 has a rectangular structure, and the second region 12 is connected to one end (i.e., the free end) of the connecting block 22 away from the body 21. In this case, the distance between the two long edges of the second region 12 and the edge of the nearest connecting block 22 is B. It should be noted that the overlapping length of the long edges and the connecting block 22 is still A.

Further, the CCS acquisition circuit further includes a plastic bracket 4, a low-voltage connector 5, a temperature sensor 6, and a patch fuse 7. The FPC and the aluminum row are arranged on the plastic bracket 4. The low-voltage connector 5, the temperature sensor 6, and the patch fuse 7 are respectively arranged on the FPC. The connections of the above components are all related to the related art and will not be described in detail herein.

Referring to FIG. 6, a battery pack includes the CCS acquisition circuit and a battery module 8. The connection between the CCS acquisition circuit and the battery module 8 (the aluminum row of the CCS acquisition circuit is connected to the pole of the battery module 8), and the connection between the CCS acquisition circuit and the battery module 8 is the prior art, and will not be described in detail herein.

The battery pack further includes a housing, and the CCS acquisition circuit and the battery module are arranged inside the housing.

In particular, the battery module 8 may expand during use, and the body 21 of the FPC will be deformed when it is collided and squeezed. The connecting block 22 mentioned above is arranged to avoid the influence of the expansion force on the connection position between the second region 12 and the FPC, and to avoid the connection between the second region 12 and the FPC from being separated.

## Claims

1. A cells contact system (CCS) connecting sheet, comprising:
a connecting sheet body (1) comprising a first region (11) and a second region (12), wherein a thickness of the second region (12) is less than a thickness of the first region (11) to form at least one step (3) at a junction therebetween, and an outer surface of the second region (12) is provided with a nickel-plating layer.

2. The CCS connecting sheet according to claim 1, wherein the thickness of the first region (11) is less than or equal to 2 mm, and the thickness of the second region (12) ranges from 0.3 mm to 1.5 mm.

3. The CCS connecting sheet according to claim 1 or claim 2, wherein the first region (11) is configured with a connecting edge (111), and the second region (12) is connected to the connection edge of the first region (11);
wherein an edge of the second region (12) connected to the connecting edge (111) is a first long edge of the second region (12);
wherein the second region (12) is configured with an edge parallel to the connecting edge (111), and the edge of the second region (12) parallel to the connecting edge (111) is a first wide edge of the second region (12); and
wherein a size of the first long edge ranges from 6 mm to 7 mm, and a size of the first wide edge ranges from 5.5 mm to 6.5 mm.

4. The CCS connecting sheet according to claim 3, wherein in the first region (11), an edge of the first region (11) parallel to the first wide edge is a second wide edge of the first region (11), and an edge of the first region (11) parallel to the first long edge is a second long edge of the first region (11); and
wherein a size of the second long edge is 8-9 times the size of the first long edge, and a size of the second wide edge is 5-6 times the size of the first wide edge.

5. The CCS connecting sheet according to claim 1, wherein a thickness of the nickel-plating layer ranges from 5 µm to 15 µm.

6. The CCS connecting sheet according to claim 2 or claim 5, wherein the connecting sheet body (1) is an aluminum sheet body or a copper sheet body.

7. The CCS connecting sheet according to claim 1 or claim 2, wherein the first region (11) and the second region (12) are integrally connected.

8. The CCS connecting sheet according to claim 1 or claim 2, wherein in a thickness direction of the first region (11), the steps (3) are provided between a bottom surface of the second region (12) and a bottom surface of the first region (11), and between a top surface of the second region (12) and a top surface of the first region (11).

9. A cells contact system (CCS) acquisition circuit, comprising a plurality of CCS connecting sheets according to claim 3 and a flexible printed circuit (FPC), wherein the plurality of CCS connecting sheets are arranged side by side to form an aluminum row, and the aluminum row is connected to the FPC.

10. The CCS acquisition circuit according to claim 9, wherein the FPC comprises a body (21) and a connecting block (22);
wherein an end of the connecting block (22) is connected to the body (21), the second region (12) is connected to the connecting block (22) and overlapped with the connecting block (22), and an overlapping length between the first long edge and the connecting block (22) ranges from 3 mm to 5 mm; and
wherein the connecting block (22) is provided with a marginal region (221) located at a side of the first long edge, the marginal region (221) extends along a direction away from the long edge, and an extending distance ranges from 1.5 mm to 3 mm.

11. The CCS acquisition circuit according to claim 10, wherein the body (21) is provided with a connecting port (211);
wherein the connecting block (22) is disposed in the connecting port (211), one end of the connecting block (22) is connected to a side wall of the connecting port (211), and the other end of the connecting block (22) is a free end.

12. The CCS acquisition circuit according to claim 11, wherein the second region (12) is provided with an avoidance port (212), and the second region (12) is connected to the connecting block (22) and is located between the avoidance port (212) and the free end.

13. The CCS acquisition circuit according to any one of claims 9-12, further comprising a plastic bracket (4), a low-voltage connector (5), a temperature sensor (6), and a patch fuse (7), wherein the FPC and the aluminum row are both arranged on the plastic bracket (4), and the low-voltage connector (5), the temperature sensor (6), and the patch fuse (7) are respectively arranged on the FPC.

14. A battery pack, comprising the CCS acquisition circuit according to any one of claims 9-13 and a battery module (8), wherein the CCS acquisition circuit is connected to the battery module (8).

15. The battery pack according to claim 14, further comprising a housing, wherein the CCS acquisition circuit and the battery module (8) are disposed inside the housing, and the aluminum row of the CCS acquisition circuit is connected to a pole of the battery module (8).
